# EUROPEAN PATENT APPLICATION

(11) **EP 4 759 578 A1**
(43) Date of publication of application: **17.06.2026**
(21) Application number: 23948706.9
(22) Date of filing: 11.08.2023
(51) Int. Cl.: B60H 1/22, B60H 1/00, H05K 7/20

(54) **WASTE HEAT RECOVERY METHOD AND APPARATUS FOR CHIP, STORAGE MEDIUM, AND VEHICLE SYSTEM**

(71) Applicant: ZHEJIANG ZEEKR INTELLIGENT TECHNOLOGY CO., LTD., Ningbo, Zhejiang 315899 (CN); Zhejiang Geely Holding Group Co., Ltd., Hangzhou, Zhejiang 310051 (CN)
(72) Inventor: LI, Weilin, Ningbo, Zhejiang 315899 (CN); HU, Lei, Ningbo, Zhejiang 315899 (CN); XU, Junbo, Ningbo, Zhejiang 315899 (CN); XIA, Songyong, Ningbo, Zhejiang 315899 (CN); WANG, Jian, Ningbo, Zhejiang 315899 (CN); XING, Xiaodong, Ningbo, Zhejiang 315899 (CN); SUN, Ligang, Ningbo, Zhejiang 315899 (CN); GE, Pengfei, Ningbo, Zhejiang 315899 (CN); CHU, Guanqun, Ningbo, Zhejiang 315899 (CN)
(74) Representative: Boult Wade Tennant LLP
(86) International application number: PCT/CN2023/112547
(87) International publication number: WO 2025/035264

(57) **Abstract**

A waste heat recovery apparatus and method for a chip, a storage medium, and a vehicle system. The chip is provided inside a housing, at least one heat pipe is provided inside the housing and a heat exchanger penetrates through the housing. One end of the heat exchanger is connected to the heat pipe, and the other end of the heat exchanger is connected to an external circulation water path provided with a valve. The waste heat recovery method includes: acquiring a temperature of the heat pipe, a temperature of coolant in the external circulation water path, and an ambient temperature, and when the ambient temperature satisfies a preset temperature and the temperature of the heat pipe is greater than the temperature of the coolant in the external circulation water path, controlling the valve to open, so as to recover waste heat of the chip by means of the heat exchanger and the coolant in the external circulation water path.

## Description

### TECHNICAL FIELD

The present disclosure relates to the technical field of waste heat recovery, in particular, to a waste heat recovery method for a chip, a computer-readable storage medium, a vehicle system and a waste heat recovery apparatus for a chip.

### BACKGROUND

When vehicles are in operation, components of the vehicles often generate heat. If this heat is not recovered and utilized in time, it will be directly dissipated, causing waste and also having an impact on the environment.

In related art, methods for waste heat recovery within an entire vehicle system or from internal chips of components include converting thermal energy into electrical energy for recovery through thermoelectric power generation utilizing temperature differences, directly recovering thermal energy via a circulating water circuit, and directly recovering thermal energy through a heat pump.

Among them, the efficiency of the power generation utilizing temperature differences is between 3% and 10%, which is low with poor recovery effects, making it difficult to be widely used in mass-produced vehicle models in actual projects. During a process of directly collecting heat energy through a cooling circuit or refrigerant circuit, the cooling circuit or refrigerant circuit needs to be pre-arranged within components. Moreover, it is difficult to install, maintain and replace them in the later stage. At the same time, it is not conducive to modularization and commonality across multiple vehicle models, resulting in poor feasibility.

### SUMMARY

The present disclosure aims to solve at least one of the technical problems in the related art to a certain extent. To this end, a first objective of the present disclosure is to propose a waste heat recovery method for a chip which recovers waste heat conducted from a chip to a heat pipe through a heat exchanger and coolant in an external circulation water path, and can improve the efficiency of heat energy recovery. Moreover, the external circulation water path is easy to install and maintain, has high universality and feasibility, and can achieve waste heat recovery in winter and cooling and temperature reduction in summer.

A second objective of the present disclosure is to propose a computer-readable storage medium.

A third objective of the present disclosure is to propose a vehicle system.

A fourth purpose of the present disclosure is to propose a waste heat recovery apparatus for a chip.

To achieve the above-mentioned objectives, in a first aspect, an embodiment of the present disclosure proposes a waste heat recovery method for a chip. The chip is provided inside a housing, at least one heat pipe is provided inside the housing, a heat exchanger is disposed through the housing, one end of the heat exchanger is connected to the heat pipe, and the other end of the heat exchanger is connected to an external circulation water path, and a valve is set in the external circulation water path. The method includes: acquiring a temperature of the heat pipe, a temperature of coolant in the external circulation water path, and an ambient temperature; when the ambient temperature satisfies a preset temperature and the temperature of the heat pipe is greater than the temperature of the coolant in the external circulation water path, controlling the valve to open, so as to recover waste heat of the chip by means of the heat exchanger and the coolant in the external circulation water path.

According to the waste heat recovery method for the chip proposed in the embodiments of the present disclosure, the waste heat conducted from the chip to the heat pipe is recovered through the heat exchanger and the coolant in the external circulation water path, which can improve the efficiency of heat energy recovery. Moreover, the external circulation water path is easy to install and maintain, has high universality and feasibility, and can achieve waste heat recovery in winter and cooling and temperature reduction in summer.

In addition, the waste heat recovery method for the chip according to the above embodiments of the present disclosure may also have the following additional technical features.

According to an embodiment of the present disclosure, the ambient temperature satisfying a preset temperature includes: the ambient temperature is less than or equal to a first preset temperature, or the ambient temperature is greater than or equal to a second preset temperature, where the first preset temperature is less than the second preset temperature.

According to an embodiment of the present disclosure, a value range of the first preset temperature is [5°C, 10°C], and a value range of the second preset temperature is [30°C, 40°C].

According to an embodiment of the present disclosure, a first heat pipe and a second heat pipe are provided inside the housing, the first heat pipe is configured to support the chip, and the second heat pipe is arranged above the chip.

According to an embodiment of the present disclosure, a groove is also provided on the first heat pipe, and the groove is configured to receive the chip.

According to an embodiment of the present disclosure, a part of the first heat pipe is configured to support the chip is provided with at least one opening.

According to an embodiment of the present disclosure, heat insulation cotton is provided on an inner side of the housing.

To achieve the above-mentioned objectives, in a second aspect, an embodiment of the present disclosure proposes a computer-readable storage medium storing a waste heat recovery program for a chip. When the waste heat recovery program for the chip is executed by a processor, the waste heat recovery method for the chip is implemented.

The computer-readable storage medium according to the above embodiment of the present disclosure can improve the recovery efficiency of the heat energy generated during the operation of the chip, has high universality and feasibility, and can achieve waste heat recovery in winter and cooling and temperature reduction in summer.

To achieve the above-mentioned objectives, in a third aspect, an embodiment of the present disclosure proposes a vehicle system. The vehicle system includes a memory, a processor and a waste heat recovery program for a chip stored in the memory and runnable on the processor, when the waste heat recovery program for the chip is executed by the processor, the waste heat recovery method for the chip is implemented.

The vehicle system according to the above embodiments of the present disclosure can improve the recovery efficiency of the heat energy generated during the operation of the chip, has high universality and feasibility, and can achieve waste heat recovery in winter and cooling and temperature reduction in summer.

To achieve the above-mentioned objectives, in a fourth aspect, an embodiment of the present disclosure proposes a waste heat recovery apparatus for a chip. The chip is provided inside a housing, at least one heat pipe is provided inside the housing, a heat exchanger is disposed through the housing, one end of the heat exchanger is connected to the heat pipe, and the other end of the heat exchanger is connected to an external circulation water path, and a valve is set in the external circulation water path. The apparatus includes: an acquiring module, configured to acquire a temperature of the heat pipe, a temperature of coolant in the external circulation water path, and an ambient temperature; a controlling module, configured to control a valve to open, so as to recover waste heat of the chip by means of the heat exchanger and the coolant in the external circulation water path, when the ambient temperature satisfies a preset temperature and the temperature of the heat pipe is greater than the temperature of the coolant in the external circulation water path.

The waste heat recovery apparatus for the chip proposed according to the embodiments of the present disclosure controls, through the controlling module, the heat exchanger and the coolant in the external circulation water path to recover the waste heat conducted from the chip to the heat pipe, which can improve the efficiency of heat energy recovery. Moreover, the external circulation water path is easy to install and maintain, has high universality and feasibility, and can achieve waste heat recovery in winter and cooling and temperature reduction in summer.

The additional aspects and advantages of the present disclosure will be partially presented in the following description, and some will become obvious from the description below or be understood through the practice of the present disclosure.

### BRIEF DESCRIPTION OF DRAWINGS

FIG. 1 is a schematic structural diagram of a component containing a chip according to an embodiment of the present disclosure.
FIG. 2 is a schematic flowchart of a waste heat recovery method for a chip according to an embodiment of the present disclosure.
FIG. 3 is a schematic structural diagram of a component of a vehicle lamp according to a specific embodiment of the present disclosure.
FIG. 4 is a schematic flowchart of a waste heat recovery method for a chip according to a specific embodiment of the present disclosure.
FIG. 5 is a block diagram of a vehicle system according to an embodiment of the present disclosure.
FIG. 6 is a block diagram of a waste heat recovery apparatus for a chip according to an embodiment of the present disclosure.

### DESCRIPTION OF EMBODIMENTS

The following describes in detail embodiments of the present disclosure. Examples of the embodiments are shown in drawings, where a same or similar label throughout indicates the same or similar components or components with a same or similar function. The embodiments described below with reference to the drawings are exemplary and are intended to explain the present disclosure, and should not be construed as limiting the present disclosure.

In the following, a waste heat recovery method for a chip, a computer-readable storage medium, a vehicle system and a waste heat recovery apparatus for a chip in the embodiments of the present disclosure are described with reference to the drawings.

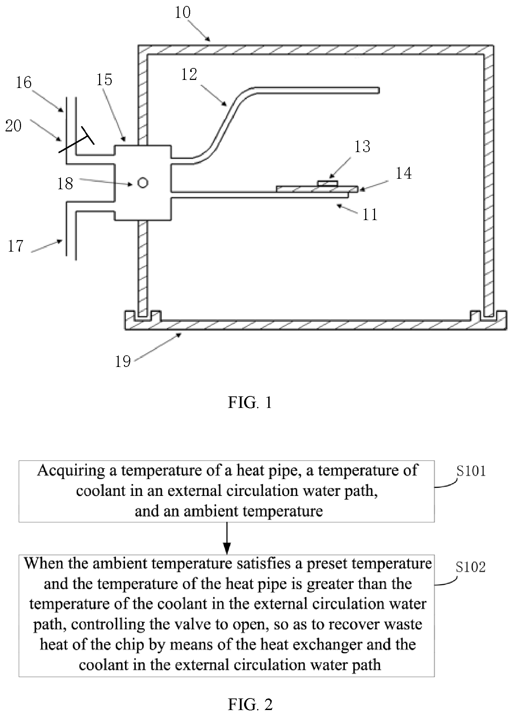

FIG. 1 is a schematic diagram of a component containing a chip according to an embodiment of the present disclosure.

Specifically, in some embodiments of the present disclosure, a chip 13 is provided inside a housing 10, and at least one heat pipe is provided inside the housing 10. A heat exchanger 15 penetrates through the housing 10, one end of the heat exchanger 15 is connected to the heat pipe, and the other end of the heat exchanger 15 is connected to an external circulation water path, in which a valve 20 is arranged. When coolant passes through the external circulation water path, heat from the heat pipe can be conducted out by the coolant through the heat exchanger 15.

FIG. 2 is a schematic flowchart of a waste heat recovery method for a chip according to an embodiment of the present disclosure.

Specifically, in some embodiments of the present disclosure, as shown in FIG. 2, a waste heat recovery method for a chip includes the following steps.

S101, acquiring a temperature of a heat pipe, a temperature of coolant in an external circulation water path, and an ambient temperature.

Specifically, in this embodiment, a temperature sensor can be set on a heat exchanger to acquire the temperature of the heat pipe, a temperature sensor can be set in the external circulation water path to acquire the temperature of the coolant in the external circulation water path, and a temperature sensor can be set outside a housing to acquire the ambient temperature. Of course, a temperature of a pipe in the external circulation water path can also be detected. Then, the temperature of the coolant can be derived based on the temperature of the pipe. Additionally, environmental information can be determined by obtaining weather temperature information released by a meteorological bureau. Moreover, the method for acquiring the temperature of the heat pipe, the temperature of the coolant in the external circulation water path, and the ambient temperature is not specified in the present disclosure.

S102, when the ambient temperature satisfies a preset temperature and the temperature of the heat pipe is greater than the temperature of the coolant in the external circulation water path, controlling the valve to open, so as to recover waste heat of the chip by means of the heat exchanger and the coolant in the external circulation water path.

Specifically, in this embodiment, when the ambient temperature is less than or equal to a first preset temperature, or the ambient temperature is greater than or equal to a second preset temperature, the first preset temperature being less than the second preset temperature, and the temperature of the heat pipe is greater than the temperature of the coolant in the external circulation water path, the valve is controlled to be opened to recover waste heat of a chip by means of the heat exchanger and the coolant in the external circulation water path. In addition, when the ambient temperature is higher than the first preset temperature but lower than the second preset temperature, the chip operates within an appropriate temperature range, it neither requires heat dissipation to prevent component erosion nor absorbs additional heat. Therefore, within this temperature range, there is no need to control the opening of the valve.

It should be noted that a value range of the first preset temperature is [5°C, 10°C], and a value range of the second preset temperature is [30°C, 40°C]. Among them, a value of the first preset temperature can be preferably set at 7°C, and a value of the second preset temperature can be preferably set at 35°C. When the ambient temperature is less than or equal to 7°C, the heat energy generated by the chip's operation can be recovered and used in other parts of a vehicle due to the low ambient temperature. Therefore, the valve needs to be opened. When the ambient temperature is greater than or equal to 35°C, it is necessary to lower the temperature of the chip's operation environment to prevent component erosion due to the high ambient temperature. Therefore, the valve also needs to be opened. Furthermore, the present disclosure does not specifically limit the values of the first preset temperature and the second preset temperature.

Further, in some embodiments of the present disclosure, a first heat pipe and a second heat pipe are provided inside the housing, the first heat pipe is configured to support the chip, and the second heat pipe is arranged above the chip.

Specifically, in this embodiment, as shown in FIG. 1, a first heat pipe 11 and a second heat pipe 12 are provided inside the housing 10. A groove (not shown in the figure) is also provided on the first heat pipe 11, and the groove can be configured to accommodate the chip 13. A part of the first heat pipe 11 configured to support the chip 13 is provided with at least one opening, which can increase the heat exchange efficiency and reduce contact thermal resistance. In addition, the heat exchange efficiency can be increased by applying thermal conductive adhesive on heat source sides of the first heat pipe 11 and the second heat pipe 12. The second heat pipe 12 is arranged above the chip 13. The heat generated by the chip 13 during operation can heat the air above it, thereby generating a heat flow. Therefore, arranging the second heat pipe 12 above the chip 13 can increase a recovery rate of waste heat. Of course, in some examples, the second heat pipe 12 can also be arranged in a ring shape, in a shape of the chip 13, to surround the chip 13. That is to say, the first heat pipe 11 and the second heat pipe 12 can also be designed in non-standard shapes, such as irregular shapes, i.e., the first heat pipe 11 and the second heat pipe 12 can be customized for a heat dissipation device.

It should be noted that, as shown in FIG. 1, a PCB (Printed Circuit Board, printed circuit board) board 14 is also placed on the first heat pipe 11. A bottom surface of the PCB board 14 is in contact with the heat source side of the first heat pipe. Thus, when the temperature of the chip 13 rises, the heat from the PCB board 14 or chip 13 will be transferred to the heat exchanger 15 through the first heat pipe 11. When the valve 20 is controlled to be opened, the coolant enters the heat exchanger 15 through an inlet pipe 16 of the external circulation water path. After absorbing the heat from the heat exchanger 15, the coolant flows out through an outlet pipe 17 of the external circulation water path, thereby collecting the heat into a heating circuit of an entire vehicle to make use of the collected heat. For example, heating a back of a seat and increasing an internal environment temperature of a vehicle body, etc. In addition, the present disclosure does not specifically limit the use of the collected heat, which can be determined based on real-time needs of a user. It should be noted that the heat exchanger 15 is also provided with a temperature sensor 18 for detecting the temperature of the heat exchanger 15, as well as a base 19 for supporting the housing 10.

Further, in some embodiments of the present disclosure, heat insulation cotton is provided on an inner side of the housing.

Specifically, in this embodiment, by providing the heat insulation cotton on the inner side of the housing, heat loss can be prevented, facilitating the maximum collection of heat. In addition, insulation materials such as foam and fiber materials can also be set on the inner side of the housing. Furthermore, the present disclosure does not specifically limit the selection of insulation materials set inside the housing. Of course, in some examples, the housing 10 can also be set as a heat pipe to participate in the waste heat recovery for a chip.

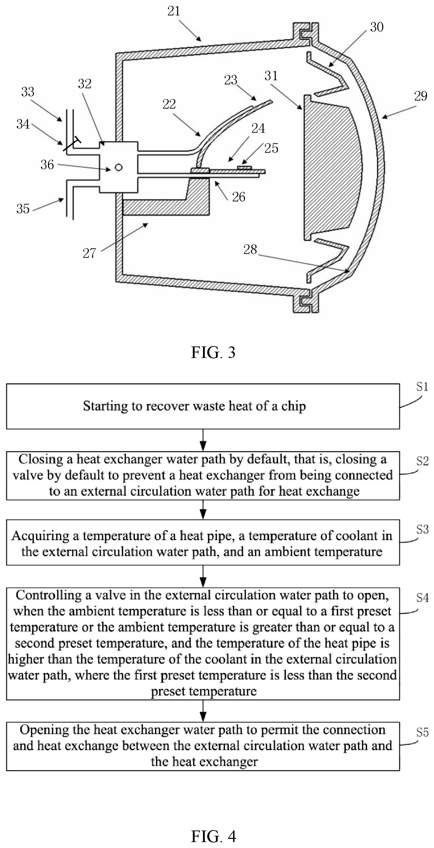

Taking a vehicle lamp as an example, as shown in FIG. 3, when the waste heat recovery method for the chip is applied to the vehicle lamp, a temperature of a vehicle lamp's chip 25 rises when it is working. The heat generated by a PCB board 24 of the vehicle lamp and/or the vehicle lamp's chip 25 will be transferred to a vehicle lamp's heat exchanger 32 through a heat pipe 26 of the vehicle lamp's PCB. Heat radiation and hot airflow rise and heat components above, such as a reflector 23, a lamp cover 29, a trim ring 30 and a lens 31. A reflector heat pipe 22, which is set above the vehicle lamp's chip 25 and is attached to the reflector 23, will transfer the heat of the reflector 23 and other components to the vehicle lamp's heat exchanger 32, thereby preventing the components from burning and failing.

A vehicle lamp's temperature sensor 36 can preferentially obtain a temperature of the heat pipe 26 of the vehicle lamp's PCB, that is, a priority of the heat pipe 26 of the vehicle lamp's PCB is greater than that of the reflector heat pipe 22. Furthermore, the present disclosure does not specifically limit the priority of the heat pipe 26 of the vehicle lamp's PCB and the reflector heat pipe 22. When the ambient temperature is less than or equal to the first preset temperature or the ambient temperature is greater than or equal to the second preset temperature, and the temperature of the heat pipe 26 of the vehicle lamp's PCB obtained by the vehicle lamp's temperature sensor 36 is greater than the temperature of the coolant in the external circulation water path, a vehicle lamp's valve 34 is controlled to be opened, and the coolant enters the vehicle lamp's heat exchanger 32 through a vehicle lamp's water inlet pipe 33 of the external circulation water path. The coolant absorbs the heat from the vehicle lamp's heat exchanger 32 and then flows out through an outlet pipe 37 of the external circulation water path, thereby collecting the heat into the vehicle's heating circuit and utilizing the collected heat. For instance, heating a back of a seat and increasing an internal environment temperature of a vehicle body, etc., thereby reducing overall energy consumption of the vehicle. The vehicle lamp also includes a bracket 27, a first housing of the vehicle lamp 21 and a second housing of the vehicle lamp 28. Among them, the bracket 27 is configured to support the heat pipe 26 of the vehicle lamp's PCB to fix the heat pipe 26 of the vehicle lamp's PCB. The first housing of the vehicle lamp 21 and the second housing of the vehicle lamp 28 are set in combination to protect internal components of the vehicle lamp. At the same time, inner sides of the first housing of the vehicle lamp 21 and the second housing of the vehicle lamp 28 can also be equipped with heat insulation cotton, which can prevent heat loss and facilitate the maximum collection of heat generated by the vehicle lamp.

It should be noted that the waste heat recovery method for the chip disclosed in the present disclosure can not only be applied to the vehicle lamp, but also to an engine, a brake pad and other places. As long as it is a heat-generating position on the vehicle, this method can be used to recover heat. The present disclosure does not need to limit the application scenarios of the waste heat recovery method for the chip.

The specific process steps of the waste heat recovery method for the chip are described below in conjunction with FIG. 4 and the specific embodiments disclosed herein. As shown in FIG. 4, the following steps are executed.

S1, starting to recover waste heat of a chip.

S2, closing a heat exchanger water path by default, that is, closing a valve by default to prevent a heat exchanger from being connected to an external circulation water path for heat exchange.

S3: acquiring a temperature of a heat pipe, a temperature of coolant in the external circulation water path, and an ambient temperature.

S4: controlling a valve in the external circulation water path to open, when the ambient temperature is less than or equal to a first preset temperature or the ambient temperature is greater than or equal to a second preset temperature, and the temperature of the heat pipe is higher than the temperature of the coolant in the external circulation water path, where the first preset temperature is less than the second preset temperature.

S5, opening the heat exchanger water path to permit the connection and heat exchange between the external circulation water path and the heat exchanger.

In sum, according to the waste heat recovery method for the chip proposed in the embodiments of the present disclosure, the waste heat conducted from the chip to the heat pipe is recovered through the heat exchanger and the coolant in the external circulation water path, which can improve the efficiency of heat energy recovery. Moreover, this waste heat recovery method has high universality and feasibility, and can achieve waste heat recovery in winter and cooling and temperature reduction in summer.

Based on the waste heat recovery method for the chip in the aforementioned embodiments of the present disclosure, the present disclosure also proposes a computer-readable storage medium on which a waste heat recovery program for a chip is stored. When the waste heat recovery program for the chip is executed by a processor, the waste heat recovery method for the chip in the aforementioned embodiments of the present disclosure is implemented.

In sum, according to the computer-readable storage medium in the above embodiments of the present disclosure, by executing the waste heat recovery program for the chip stored on the computer-readable storage medium through the processor, the recovery efficiency of the heat energy generated during the operation of the chip can be improved. Moreover, this waste heat recovery method has high universality and feasibility, and can achieve waste heat recovery in winter and cooling and temperature reduction in summer.

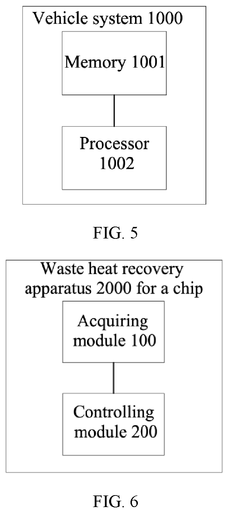

FIG. 5 is a block diagram of a vehicle system according to an embodiment of the present disclosure.

Further, as shown in FIG. 5, based on the waste heat recovery method for the chip in the aforementioned embodiments of the present disclosure, the present disclosure also proposes a vehicle system 1000, including a memory 1001, a processor 1002 and a waste heat recovery program for the chip stored in the memory 1001 and runnable on the processor 1002. When the processor 1002 executes the waste heat recovery program, the waste heat recovery method for the chip in the above-mentioned embodiments of the present disclosure is implemented.

In sum, according to the vehicle system of the present disclosure embodiment, by executing the waste heat recovery program for the chip stored in the memory through the processor, the recovery efficiency of the heat energy generated during the operation of the chip can be improved. Moreover, this waste heat recovery method has high universality and feasibility, and can achieve waste heat recovery in winter and cooling and temperature reduction in summer.

FIG. 6 is a block diagram of a waste heat recovery apparatus for a chip according to an embodiment of the present disclosure.

As shown in FIG. 6, the waste heat recovery apparatus 2000 for the chip includes an acquiring module 100 and a controlling module 200. The chip is provided inside a housing, at least one heat pipe is provided inside the housing, a heat exchanger is disposed through the housing. One end of the heat exchanger is connected to the heat pipe, and the other end of the heat exchanger is connected to an external circulation water path. A valve is set in the external circulation water path.

The acquiring module 100 is configured to acquire a temperature of the heat pipe, a temperature of coolant in the external circulation water path, and an ambient temperature. The controlling module 200 is configured to control a valve to open, so as to recover waste heat of the chip by means of the heat exchanger and the coolant in the external circulation water path, when the ambient temperature satisfies a preset temperature and the temperature of the heat pipe is greater than the temperature of the coolant in the external circulation water path.

In some embodiments of the present disclosure, the ambient temperature satisfying the preset temperature includes: the ambient temperature is less than or equal to a first preset temperature, or the ambient temperature is greater than or equal to a second preset temperature, where the first preset temperature is less than the second preset temperature.

In some embodiments of the present disclosure, a value range of the first preset temperature is [5°C, 10°C], and a value range of the second preset temperature is [30°C, 40°C].

In some embodiments of the present disclosure, a first heat pipe and a second heat pipe are provided inside the housing, the first heat pipe is configured to support the chip, and the second heat pipe is arranged above the chip.

In some embodiments of the present disclosure, a groove is also provided on the first heat pipe, and the groove is configured to receive the chip.

In some embodiments of the present disclosure, a part of the first heat pipe is configured to support the chip is provided with at least one opening.

In some embodiments of the present disclosure, heat insulation cotton is provided on an inner side of the housing.

It should be noted that for other specific implementation methods of the waste heat recovery apparatus for the chip proposed in the embodiments of the present disclosure, reference can be made to the specific implementation methods of the waste heat recovery method for the chip in the aforementioned embodiments of the present disclosure. To reduce redundancy, they will not be elaborated here.

In sum, the waste heat recovery apparatus for the chip proposed according to the embodiments of the present disclosure controls, through the controlling module, the heat exchanger and the coolant in the external circulation water path to recover the waste heat conducted from the chip to the heat pipe, which can improve the efficiency of heat energy recovery. Moreover, the external circulation water path is easy to install and maintain, has high universality and feasibility, and can achieve waste heat recovery in winter and cooling and temperature reduction in summer.

## Claims

1. A waste heat recovery method for a chip, **characterized in that**, the chip is provided inside a housing, at least one heat pipe is provided inside the housing, a heat exchanger is disposed through the housing, one end of the heat exchanger is connected to the heat pipe, and the other end of the heat exchanger is connected to an external circulation water path, and a valve is set in the external circulation water path, the method comprises:
acquiring a temperature of the heat pipe, a temperature of coolant in the external circulation water path, and an ambient temperature;
when the ambient temperature satisfies a preset temperature and the temperature of the heat pipe is greater than the temperature of the coolant in the external circulation water path, controlling the valve to open, to recover waste heat of the chip by means of the heat exchanger and the coolant in the external circulation water path.

2. The waste heat recovery method according to claim 1, wherein the ambient temperature satisfying a preset temperature comprises:
the ambient temperature is less than or equal to a first preset temperature, or the ambient temperature is greater than or equal to a second preset temperature, wherein the first preset temperature is less than the second preset temperature.

3. The waste heat recovery method according to claim 2, wherein a value range of the first preset temperature is [5°C, 10°C], and a value range of the second preset temperature is [30°C, 40°C].

4. The waste heat recovery method according to any one of claims 1 to 3, wherein a first heat pipe and a second heat pipe are provided inside the housing, the first heat pipe is configured to support the chip, and the second heat pipe is arranged above the chip.

5. The waste heat recovery method according to claim 4, wherein a groove is also provided on the first heat pipe, and the groove is configured to receive the chip.

6. The waste heat recovery method according to claim 4 or 5, wherein a part of the first heat pipe is configured to support the chip is provided with at least one opening.

7. The waste heat recovery method according to any one of claims 1 to 6, wherein heat insulation cotton is provided on an inner side of the housing.

8. A computer-readable storage medium storing a waste heat recovery program for a chip, **characterized in that**, when the waste heat recovery program for the chip is executed by a processor, the waste heat recovery method for the chip according to any one of claims 1 to 7 is implemented.

9. A vehicle system, **characterized by** comprising a memory, a processor and a waste heat recovery program for a chip stored in the memory and runnable on the processor, when the waste heat recovery program for the chip is executed by the processor, the waste heat recovery method for the chip according to any one of claims 1 to 7 is implemented.

10. A waste heat recovery apparatus for a chip, **characterized in that**, the chip is provided inside a housing, at least one heat pipe is provided inside the housing, a heat exchanger is disposed through the housing, one end of the heat exchanger is connected to the heat pipe, and the other end of the heat exchanger is connected to an external circulation water path, and a valve is set in the external circulation water path, the apparatus comprises:
an acquiring module, configured to acquire a temperature of the heat pipe, a temperature of coolant in the external circulation water path, and an ambient temperature;
a controlling module, configured to control a valve to open, so as to recover waste heat of the chip by means of the heat exchanger and the coolant in the external circulation water path, when the ambient temperature satisfies a preset temperature and the temperature of the heat pipe is greater than the temperature of the coolant in the external circulation water path.
